# EUROPEAN PATENT APPLICATION

(11) **EP 4 231 096 A1**
(43) Date of publication of application: **23.08.2023**
(21) Application number: 22157745.5
(22) Date of filing: 21.02.2022
(51) Int. Cl.: G03F 7/20, G06N 3/08, G06T 7/00

(54) **METHODS OF METROLOGY**

(71) Applicant: ASML Netherlands B.V., 5500 AH Veldhoven (NL)
(72) Inventor: BATISTAKIS, Chrysostomos, 5500 AH Veldhoven (NL); ZHANG, Huaichen, 5500 AH Veldhoven (NL)
(74) Representative: ASML Netherlands B.V.

(57) **Abstract**

Disclosed is a method for determining a parameter of interest relating to at least one structure formed on a substrate in a manufacturing process. The method comprises obtaining metrology data relating to a plurality of measurements of the parameter of interest at a respective plurality of measurement locations on the substrate and layout data relating to a layout of a pattern to be applied to said structure, said pattern comprising said at least one structure. The method comprises determining a value for a parameter of interest at one or more locations on the substrate different from said measurement locations from said metrology data and layout data using a trained model, having been trained to be able to interpolate said metrology data using said layout data to an expected value for the parameter of interest.

## Description

### BACKGROUND

### Field of the Invention

**0001** The present invention relates to methods of metrology performed to maintain performance in the manufacture of devices by patterning processes such as lithography. The invention further relates to methods of manufacturing devices using lithographic techniques. The invention yet further relates to computer program products for use in implementing such methods.

### Related Art

**0002** A lithographic process is one in which a lithographic apparatus applies a desired pattern onto a substrate, usually onto a target portion of the substrate, after which various processing chemical and/or physical processing steps work through the pattern to create functional features of a complex product. The accurate placement of patterns on the substrate is a chief challenge for reducing the size of circuit components and other products that may be produced by lithography. In particular, the challenge of measuring accurately the features on a substrate which have already been laid down is a critical step in being able to position successive layers of features in superposition accurately enough to produce working devices with a high yield. A particularly important parameter of interest is overlay, which should, in general, be controlled to be within a few tens of nanometers in today's sub-micron semiconductor devices, down to a few nanometers in the most critical layers.

**0003** Consequently, modern lithography apparatuses involve extensive measurement or 'mapping' operations prior to the step of actually exposing or otherwise patterning the substrate at a target location. However, there is typically only sparse overlay data available due to throughput requirements. Therefore, fitting models (polynomials) and/or other data indicative of overlay (such as alignment data) may be used to derive a dense overlay data map. Such a method is described, for example, in US 10990018B2, which is incorporated herein by reference.

**0004** It would be desirable to improve inference and/or mapping of a parameter of interest such as overlay.

### SUMMARY OF THE INVENTION

**0005** According to a first aspect of the present invention there is provided a method for determining a parameter of interest relating to at least one structure formed on a substrate in a manufacturing process, the method comprising: obtaining metrology data relating to a plurality of measurements of the parameter of interest at a respective plurality of measurement locations on the substrate; obtaining layout data relating to a layout of a pattern to be applied to said structure, said pattern comprising said at least one structure; obtaining a trained model, having been trained to be able to interpolate said metrology data using said layout data to an expected value for the parameter of interest; and determining a value for a parameter of interest at one or more locations on the substrate different from said measurement locations from said metrology data and layout data using said trained model.

0006 According to a second aspect of the present invention there is provided a computer program product containing one or more sequences of machine-readable instructions for implementing calculating steps in a method according to the first aspect of the invention as set forth above 0007 The invention yet further provides a processing arrangement and metrology device comprising the computer program of the second aspect.

0008 These and other aspects and advantages of the apparatus and methods disclosed herein will be appreciated from a consideration of the following description and drawings of exemplary embodiments.

### BRIEF DESCRIPTION OF THE DRAWINGS

0009 Embodiments of the invention will now be described, by way of example only, with reference to the accompanying schematic drawings in which corresponding reference symbols indicate corresponding parts, and in which:
Figure 1 depicts a lithographic apparatus suitable for use in an embodiment of the present invention;
Figure 2 depicts a lithographic cell or cluster in which an inspection apparatus according to the present invention may be used;
Figure 3 illustrates schematically measurement and exposure processes in the apparatus of Figure 1, according to known practice;
Figure 4(a) is a flowchart describing a method of training a model according to an embodiment; and
Figure 4(b) is a flowchart describing a method of using the model trained according to Figure 4(a) to regress a value for a parameter of interest according to an embodiment.

### DETAILED DESCRIPTION OF EXEMPLARY EMBODIMENTS

0010 Before describing embodiments of the invention in detail, it is instructive to present an example environment in which embodiments of the present invention may be implemented.

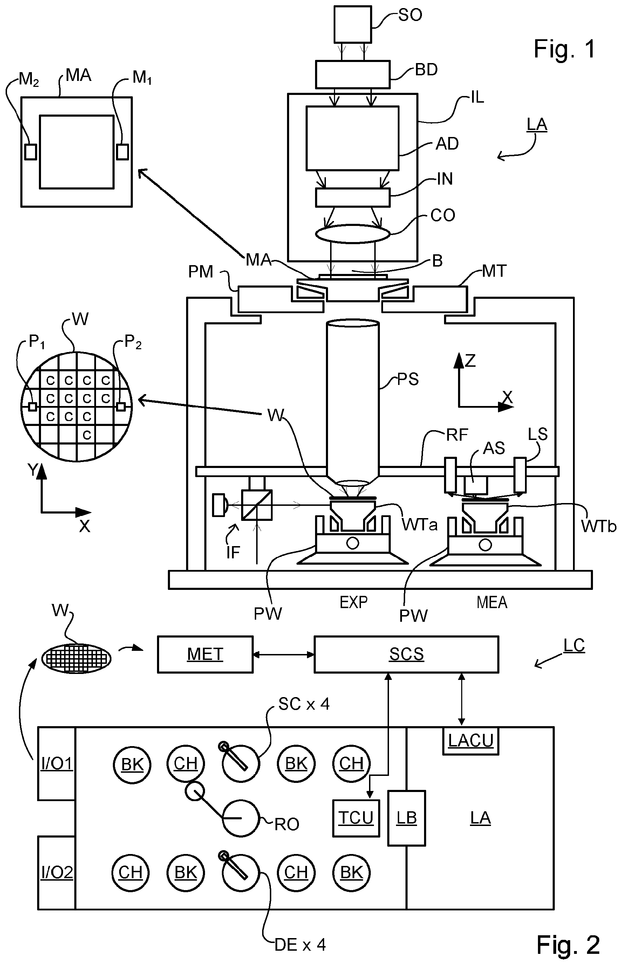

0011 Figure 1 schematically depicts a lithographic apparatus LA. The apparatus includes an illumination system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; two substrate tables (e.g., a wafer table) WTa and WTb each constructed to hold a substrate (e.g., a resist coated wafer) W and each connected to a second positioner PW configured to accurately position the substrate in accordance with certain parameters; and a projection system (e.g., a refractive projection lens system) PS configured to project a pattern imparted to the radiation beam B by patterning device MA onto a target portion C (e.g., including one or more dies) of the substrate W. A reference frame RF connects the various components, and serves as a reference for setting and measuring positions of the patterning device and substrate and of features on them.

0012 The illumination system may include various types of optical components, such as refractive, reflective, magnetic, electromagnetic, electrostatic or other types of optical components, or any combination thereof, for directing, shaping, or controlling radiation. For example, in an apparatus using extreme ultraviolet (EUV) radiation, reflective optical components will normally be used.

0013 The patterning device support holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support MT may be a frame or a table, for example, which may be fixed or movable as required. The patterning device support may ensure that the patterning device is at a desired position, for example with respect to the projection system.

0014 The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

0015 As here depicted, the apparatus is of a transmissive type (e.g., employing a transmissive patterning device). Alternatively, the apparatus may be of a reflective type (e.g., employing a programmable mirror array of a type as referred to above, or employing a reflective mask). Examples of patterning devices include masks, programmable mirror arrays, and programmable LCD panels. Any use of the terms "reticle" or "mask" herein may be considered synonymous with the more general term "patterning device." The term "patterning device" can also be interpreted as referring to a device storing in digital form pattern information for use in controlling such a programmable patterning device.

0016 The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

0017 The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems.

0018 In operation, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

0019 The illuminator IL may for example include an adjuster AD for adjusting the angular intensity distribution of the radiation beam, an integrator IN and a condenser CO. The illuminator may be used to condition the radiation beam, to have a desired uniformity and intensity distribution in its cross section.

0020 The radiation beam B is incident on the patterning device MA, which is held on the patterning device support MT, and is patterned by the patterning device. Having traversed the patterning device (e.g., mask) MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WTa or WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

0021 Patterning device (e.g., mask) MA and substrate W may be aligned using mask alignment marks M1, M2 and substrate alignment marks PI, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment marks may also be included within dies, in amongst the device features, in which case it is desirable that the markers be as small as possible and not require any different imaging or process conditions than adjacent features. The alignment system, which detects the alignment markers, is described further below.

0022 The depicted apparatus could be used in a variety of modes. In a scan mode, the patterning device support (e.g., mask table) MT and the substrate table WT are scanned synchronously while a pattern imparted to the radiation beam is projected onto a target portion C (i.e., a single dynamic exposure). The speed and direction of the substrate table WT relative to the patterning device support (e.g., mask table) MT may be determined by the (de-) magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In so-called "maskless" lithography, a programmable patterning device is held stationary but with a changing pattern, and the substrate table WT is moved or scanned.

**0023** Combinations and/or variations on the above described modes of use or entirely different modes of use may also be employed.

**0024** Lithographic apparatus LA is of a so-called dual stage type which has two substrate tables WTa, WTb and two stations - an exposure station EXP and a measurement station MEA - between which the substrate tables can be exchanged. While one substrate on one substrate table is being exposed at the exposure station, another substrate can be loaded onto the other substrate table at the measurement station and various preparatory steps carried out. This enables a substantial increase in the throughput of the apparatus. On a single stage apparatus, the preparatory steps and exposure steps need to be performed sequentially on the single stage, for each substrate. The preparatory steps may include mapping the surface height contours of the substrate using a level sensor LS and measuring the position of alignment markers on the substrate using an alignment sensor AS. If the position sensor IF is not capable of measuring the position of the substrate table while it is at the measurement station as well as at the exposure station, a second position sensor may be provided to enable the positions of the substrate table to be tracked at both stations, relative to reference frame RF. Other arrangements are known and usable instead of the dual-stage arrangement shown. For example, other lithographic apparatuses are known in which a substrate table and a measurement table are provided. These are docked together when performing preparatory measurements, and then undocked while the substrate table undergoes exposure.

**0025** As shown in Figure 2, the lithographic apparatus LA forms part of a lithographic cell LC, also sometimes referred to a lithocell or cluster, which also includes apparatus to perform pre- and post-exposure processes on a substrate. Conventionally these include spin coaters SC to deposit resist layers, developers DE to develop exposed resist, chill plates CH and bake plates BK. A substrate handler, or robot, RO picks up substrates from input/output ports I/O1, I/O2, moves them between the different process apparatus and delivers then to the loading bay LB of the lithographic apparatus. These devices, which are often collectively referred to as the track, are under the control of a track control unit TCU which is itself controlled by the supervisory control system SCS, which also controls the lithographic apparatus via lithography control unit LACU. Thus, the different apparatus can be operated to maximize throughput and processing efficiency.

**0026** In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly a manufacturing facility in which lithocell LC is located also includes metrology system MET which receives some or all of the substrates W that have been processed in the lithocell. Metrology results are provided directly or indirectly to the supervisory control system SCS. If errors are detected, adjustments may be made to exposures of subsequent substrates.

0027 Within metrology system MET, an inspection apparatus is used to determine the properties of the substrates, and in particular, how the properties of different substrates or different layers of the same substrate vary from layer to layer. The inspection apparatus may be integrated into the lithographic apparatus LA or the lithocell LC or may be a stand-alone device. To enable most rapid measurements, it may be desirable that the inspection apparatus measure properties in the exposed resist layer immediately after the exposure. However, not all inspection apparatus have sufficient sensitivity to make useful measurements of the latent image. Therefore measurements may be taken after the post-exposure bake step (PEB) which is customarily the first step carried out on exposed substrates and increases the contrast between exposed and unexposed parts of the resist. At this stage, the image in the resist may be referred to as semi-latent. It is also possible to make measurements of the developed resist image - at which point either the exposed or unexposed parts of the resist have been removed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

0028 The metrology step with metrology system MET can also be done after the resist pattern has been etched into a product layer. The latter possibility limits the possibilities for rework of faulty substrates but may provide additional information about the performance of the manufacturing process as a whole.

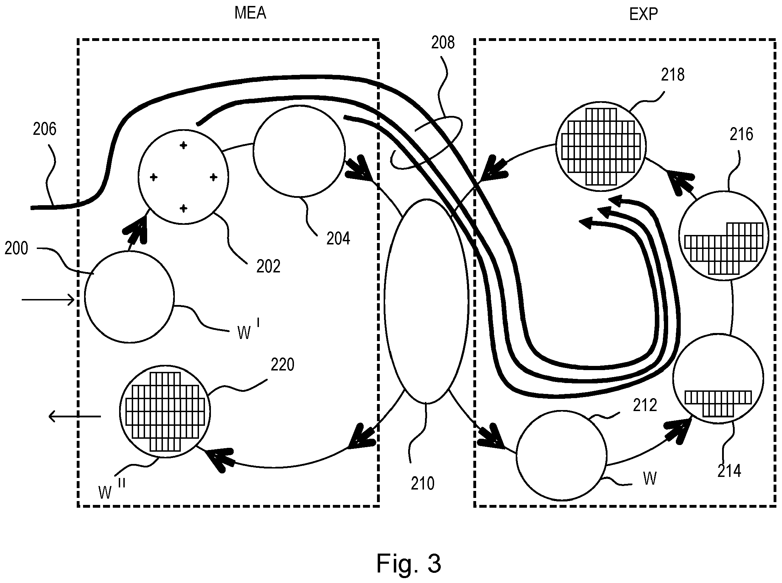

0029 Figure 3 illustrates the steps to expose target portions (e.g. dies) on a substrate W in the dual stage apparatus of Figure 1. The process according to conventional practice will be described first. The present disclosure is by no means limited to dual stage apparatus of the illustrated type. The skilled person will recognize that similar operations are performed in other types of lithographic apparatus, for example those having a single substrate stage and a docking metrology stage.

0030 On the left hand side within a dotted box are steps performed at measurement station MEA, while the right hand side shows steps performed at exposure station EXP. From time to time, one of the substrate tables WTa, WTb will be at the exposure station, while the other is at the measurement station, as described above. For the purposes of this description, it is assumed that a substrate W has already been loaded into the exposure station. At step 200, a new substrate W' is loaded to the apparatus by a mechanism not shown. These two substrates are processed in parallel in order to increase the throughput of the lithographic apparatus.

**0031** Referring initially to the newly-loaded substrate W', this may be a previously unprocessed substrate, prepared with a new photo resist for first time exposure in the apparatus. In general, however, the lithography process described will be merely one step in a series of exposure and processing steps, so that substrate W' has been through this apparatus and/or other lithography apparatuses, several times already, and may have subsequent processes to undergo as well. Particularly for the problem of improving overlay performance, the task is to ensure that new patterns are applied in exactly the correct position on a substrate that has already been subjected to one or more cycles of patterning and processing. Each patterning step can introduce positional deviations in the applied pattern, while subsequent processing steps progressively introduce distortions in the substrate and/or the pattern applied to it that must be measured and corrected for, to achieve satisfactory overlay performance.

0032 The previous and/or subsequent patterning step may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation. Some layers may be patterned by steps that are alternative or supplementary to exposure in the illustrated lithographic apparatus. Such alternative and supplementary techniques include for example imprint lithography, self-aligned multiple patterning and directed self-assembly. Similarly, other processing steps performed per layer (e.g., CMP and etch) may be performed on different apparatuses per layer.

0033 At 202, alignment measurements using the substrate marks PI etc. and image sensors (not shown) are used to measure and record alignment of the substrate relative to substrate table WTa/WTb. In addition, several alignment marks across the substrate W' will be measured using alignment sensor AS. These measurements are used in one embodiment to establish a substrate model (sometimes referred to as the "wafer grid"), which maps very accurately the distribution of marks across the substrate, including any distortion relative to a nominal rectangular grid.

0034 At step 204, a map of wafer height (Z) against X-Y position is measured also using the level sensor LS. Primarily, the height map is used only to achieve accurate focusing of the exposed pattern. It may be used for other purposes in addition.

0035 When substrate W' was loaded, recipe data 206 were received, defining the exposures to be performed, and also properties of the wafer and the patterns previously made and to be made upon it. Where there is a choice of alignment marks on the substrate, and where there is a choice of settings of an alignment sensor, these choices are defined in an alignment recipe among the recipe data 206. The alignment recipe therefore defines how positions of alignment marks are to be measured, as well as which marks.

**0036** At 210, wafers W' and W are swapped, so that the measured substrate W' becomes the substrate W entering the exposure station EXP. In the example apparatus of Figure 1, this swapping is performed by exchanging the supports WTa and WTb within the apparatus, so that the substrates W, W' remain accurately clamped and positioned on those supports, to preserve relative alignment between the substrate tables and substrates themselves. Accordingly, once the tables have been swapped, determining the relative position between projection system PS and substrate table WTb (formerly WTa) is all that is necessary to make use of the measurement information 202, 204 for the substrate W (formerly W') in control of the exposure steps. At step 212, reticle alignment is performed using the mask alignment marks M1, M2. In steps 214, 216, 218, scanning motions and radiation pulses are applied at successive target locations across the substrate W, in order to complete the exposure of a number of patterns.

**0037** By using the alignment data and height map obtained at the measuring station in the performance of the exposure steps, these patterns are accurately aligned with respect to the desired locations, and, in particular, with respect to features previously laid down on the same substrate. The exposed substrate, now labeled W" is unloaded from the apparatus at step 220, to undergo etching or other processes, in accordance with the exposed pattern.

**0038** Presently, overlay information is extracted using either direct metrology methods or indirect metrology methods. Direct metrology methods such as decap scanning electron microscope (SEM) metrology and/or high-voltage SEM are too slow for inline overlay metrology and, in the case of decap metrology, destructive of the device being measured. Indirect metrology methods, such as scatterometry based metrology on optical targets, are typically performed on a small set of discrete locations, with a full field and/or full wafer overlay map being constructed by interpolating the measured overlay values at those discrete locations. However, the interpolation or polynomial fitting ignores any high-spatial frequency overlay component distribution which may originate from various process steps (e.g., etching and/or polishing steps). Therefore the subsequent overlay optimization based on this modeling is unaware of this high-spatial frequency overlay component distribution.

**0039** A method for predicting overlay at high spatial frequency is proposed herein. Such a method may comprise obtaining metrology data comprising values for a parameter of interest (e.g., overlay) relating to a plurality of measurement locations on a substrate. The metrology data may comprise, for example, after develop inspection (ADI) overlay data measured prior to certain processing steps such as etching and/or polishing (chemical-mechanical polishing CMP) or after etch inspection (AEI) overlay data measured subsequent to those processing steps. For example, the metrology data may comprise optically measured data, e.g., scatterometer data measured from a (e.g., sparse) layout of metrology targets. A metrology target in this context may comprise a structure exposed for the purpose of metrology, or another type of structure, such as actual (functional) device structure, on which metrology can be performed. The proposed method further comprises obtaining layout data, e.g., low resolution layout data such as layout data at a resolution defined by having a pixel size 0. 1µm or greater, 0.38µm or greater, 0.4µm or greater, 0.5µm or greater, 0.8µm or greater or approximately 1µm. A trained model such as a machine learning model or a (convolutional) neural network may be used to regress said metrology data and low resolution layout data to a value for a parameter of interest at one or more locations on the substrate different from said measurement locations.

**0040** In an embodiment, the method may comprise determining a parameter of interest (e.g., overlay) spatial distribution or map over a substrate portion (e.g., an exposure field) and/or over the entire substrate.

**0041** The model may be trained using low resolution layout data, e.g., pattern density data with dense overlay metrology data. The dense overlay metrology data may comprise AEI overlay data. In embodiments where the model is trained to regress ADI overlay data to AEI overlay data, the trained model may further be trained using dense ADI overlay data. The model may be trained to regress the low resolution layout data and sparse overlay data to dense overlay data (e.g., dense AEI overlay data). In other words, the model may be trained to "densify" sparse metrology data using the low resolution layout data. In this manner, only a few measurements need to be made within a field during production, with the trained model used to interpolate the measurements to obtain a more dense map of the field.

**0042** The low resolution layout data may comprise a pattern density spatial distribution or pattern density map. Pattern density maps are low-resolution GDS (graphics design system) files or GDSII files. Due to the large size of GDS files, they are typically downscaled to a low resolution pattern density map in order to be able to process them sufficiently quickly for die-scale applications. A typical resolution of a pattern density map is a 1µm pixel size.

**0043** Pattern density may be defined as the ratio of the patterned area to the total area of a window being considered. As such, the pattern density is dependent on the window chosen; i.e., it depends on the size and shape of the window. When using a large window, the pattern density at each location is averaged over a large area, which would exhibit a low-frequency profile. When using a small window, pattern density is more determined by the adjacent patterns in a very local area.

**0044** It is also known that certain processing effects affect (AEI) overlay, such as etch and CMP steps. For example, overlay may be affected by intra-die systematic (IDS) variation, which refers to the systematic variation that is repeated on every die, which originates from such fabrication steps repeated at the die level. It is known that IDS variation can be induced by the designed layout patterns on the mask. In particular, the local pattern density can have an effect. For example, etching is influenced by the pattern density PD. The chemistry of the etching plasma above the chip, and therefore the etch rate, selectivity and anisotropy depend on the fraction of photoresist and the fraction of etching waste products generated during the etch process. Another process that can be affected by pattern density is CMP.

**0045** As such, a suitable machine learning model can be trained to infer (e.g., AEI) overlay from low resolution layout data such as pattern density data in combination with sparse (e.g., ADI or AEI) overlay metrology. In this way, dense overlay maps (at field level or wafer level) which equate to AEI overlay may be obtained by sparse metrology. This allows such overlay mapping to be performed on a per-wafer basis, as it is possible to perform such sparse ADI metrology on every wafer. This in turn enables wafer-level overlay monitoring and control. The training may train the model to interpolate sparse AEI metrology to dense AEI overlay data using low resolution layout data, in which case only dense AEI overlay data is required as an input, in addition to the low resolution layout data. Alternatively, the training may train the model to interpolate sparse ADI metrology to dense AEI overlay data using low resolution layout data, in which case both dense ADI data and dense AEI overlay data may be used for training.

**0046** The model may be trained to operate at a field level, to interpolate sparse metrology data within a field to dense metrology data for that field (by its nature, the layout data will relate to a field). However, the model may be used to determine wafer overlay maps, e.g., by using a wafer scale fingerprint. One method would be to use the wafer scale fingerprint (e.g., as measured over one or more wafers) as in input to the model, such that the model is trained to apply the wafer scale fingerprint during interpolation, to provide a full wafer overlay map (dense overlay data over the whole wafer). In another approach, the model may be trained using dense overlay data over the whole wafer, on a per-field basis; e.g., per-field training based on wafer location. The model can then be used in combination with a wafer coordinate (i.e., identifying a field) to regress sparse overlay data to dense overlay data appropriate for that field or wafer region.

**0047** As an alternative to optical or scatterometer data, the metrology data used to train the model and as an input to the trained model to infer overlay, as described above, may comprise one of: dense connectivity e-test data (e.g., voltage contrast data) or dense direct SEM measurement data (e.g., CDSEM, de-cap SEM, cross-sectional SEM data). In this manner, the model may be trained to densify these types of data, based on a sparse metrology input.

**0048** In the context of this disclosure, sparse metrology data may comprise metrology data measured at 30-1000 points per wafer, e.g., fewer than 1000 points, fewer than 100 points, or fewer or equal to 30 points. This may translate, for example, to fewer than 20, fewer than 10, fewer than 5, fewer than 4, fewer than 3 or fewer than 2 measurements per field. By another metric, sparse sampling may describe a sampling with greater than 100µm spacing in both x and y, greater than 1mm spacing in both x and y, greater than 5mm spacing in both x and y, greater than 10 mm spacing in both x and y, greater than 20 mm spacing in both x and y or greater than 30 mm spacing in both x and y. For training, dense sampling (dense metrology data) can describe more than 10k points per wafer and/or a sampling at less than 100µm spacing in both x and y.

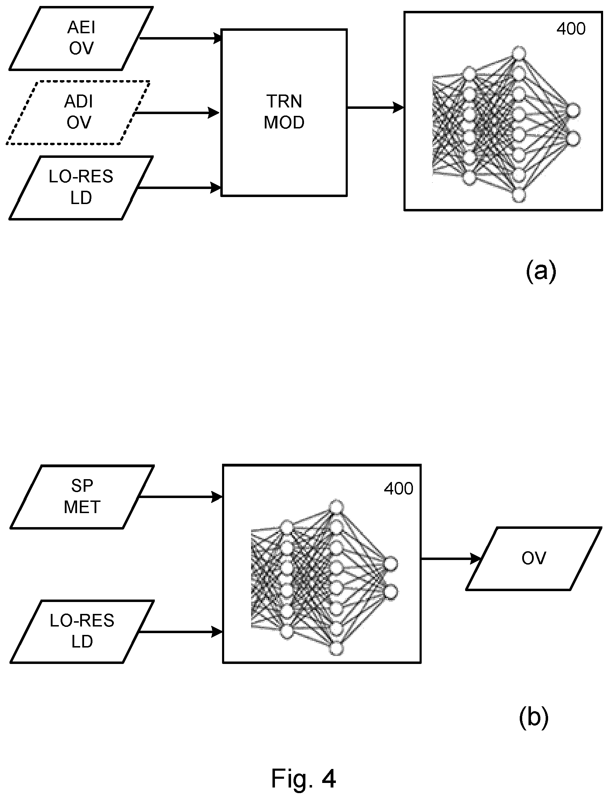

**0049** Figure 4(a) is a flow diagram of a proposed training phase of such a method. Dense AEI overlay data AEI OV and low resolution layout data LO RED LD , e.g., pattern density data is used to train a machine learning model TRN MOD. Depending on its proposed application use-case (regression of AEI data or ADI data), dense ADI overlay data ADI OV may also be provided. The training may comprise training the model to interpolate or densify sparse sampling of the ADI metrology data or AEI metrology data using the low resolution layout data LO RED LD, such that the densified (modeled) data resembles the actual densely sampled metrology data (e.g., as close to within a threshold difference). The machine learning model may be a neural network or convolutional neural network (CNN). Once training is complete, the training phase will yield trained model 400, having been trained for a particular layout or part thereof.

**0050** The pattern density data may comprise numerous (e.g., on the order of thousands) of cropped images of pattern density maps labeled by their relative measured overlay values. The measured overlay value may relate to overlay at a common point within all the images, e.g., overlay at the center of each image. The overlay may be measured via AEI metrology using a scatterometer or SEM for example.

**0051** The method may be repeated for various mask designs (i.e., pattern density maps), such that the CNN is trained to be able to directly regress sparse overlay data, a pattern density image and wafer coordinate to the expected overlay values.

**0052** The training step TRN MOD may comprise beginning training using pattern density maps covering a small area (small window), and increasing stepwise the area of the pattern density map used to train the neural network until the modeling accuracy saturates; i.e., there is no longer any (significant) improvement in modeling accuracy. That will indicate that long-range pattern density effect is correctly taken into account.

**0053** Figure 4(b) is a flow diagram illustrating an inference phase or production phase of the proposed method. sparse metrology data (e.g., ADI or AEI metrology data) SP MET at a small number of locations (e.g., such that in-line per-wafer metrology is feasible) and low resolution layout data LO RED LD, e.g., pattern density data for the structures being exposed is fed into trained model 400. The trained model regresses this sparse metrology data and low resolution layout data to overlay values OV over a field and/or the wafer. As such, the model can be used to generate dense field or wafer overlay maps based on inputting sparse overlay data and a pattern density map, where an overlay map may comprise a spatial distribution of overlay vectors across the field/substrate, each vector having a direction of the overlay and a magnitude of the overlay. Overlay can then be estimated for any wafer coordinate based on the overlay map.

**0054** The predicted full wafer overlay map may be used to optimize exposure setting for improving on-product overlay performance of the entire field or certain critical areas/features.

**0055** In summary, the proposed method enables the use of a trained neural network and a few sparsely sampled overlay values to predict the high resolution full wafer overlay map, thereby providing a high accuracy densification of overlay data across wafer. In this way, per-wafer correction is possible.

0056 In association with the hardware of the lithographic apparatus and the lithocell LC, an embodiment may include a computer program containing one or more sequences of machine-readable instructions for causing the processors of the lithographic manufacturing system to implement methods of model mapping and control as described above. This computer program may be executed for example in a separate computer system employed for the image calculation/control process. Alternatively, the calculation steps may be wholly or partly performed within a processor a metrology tool, and/or the control unit LACU and/or supervisory control system SCS of Figures 1 and 2. There may also be provided a data storage medium (e.g., semiconductor memory, magnetic or optical disk) having such a computer program stored therein in non-transient form.

**0057** Although specific reference may have been made above to the use of embodiments of the invention in the context of optical lithography, it will be appreciated that the invention may be used in other patterning applications, for example imprint lithography. In imprint lithography, topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

**0058** Further embodiments of the invention are disclosed in the list of numbered clauses below:
1. A method for determining a parameter of interest relating to at least one structure formed on a substrate in a manufacturing process, the method comprising:
   obtaining metrology data relating to a plurality of measurements of the parameter of interest at a respective plurality of measurement locations on the substrate;
   obtaining layout data relating to a layout of a pattern to be applied to said structure, said pattern comprising said at least one structure;
   obtaining a trained model, having been trained to interpolate said metrology data using said layout data to an expected value for the parameter of interest; and
   determining a value for a parameter of interest at one or more locations on the substrate different from said measurement locations from said metrology data and layout data using said trained model.
2. A method according to clause 1, wherein said parameter of interest is overlay.
3. A method according to clause 1 or 2, wherein said metrology data comprises after develop inspection metrology data measured prior to an etching and/or a polishing step.
4. A method according to clause 1 or 2, wherein said metrology data comprises after etch inspection metrology data measured subsequent to an etching and/or a polishing step.
5. A method according to any preceding clause, wherein said metrology data is measured using a scatterometer.
6. A method according to any of clauses 1 to 5, wherein said metrology data comprises one of: connectivity e-test data or scanning electron microscope measurement data.
7. A method according to any preceding clause, wherein said plurality of measurement locations number fewer than 1000 locations per substrate.
8. A method according to any of clauses 1 to 6, wherein said plurality of measurement locations number fewer than 100 locations per substrate.
9. A method according to any of clauses 1 to 6, wherein said plurality of measurement locations number fewer than 30 locations per substrate.
10. A method according to any preceding clause, wherein said plurality of measurement locations have an average spacing greater than 1 mm spacing in both directions of a substrate plane.
11. A method according to any of clauses 1 to 9, wherein said plurality of measurement locations have an average spacing greater than 10 mm in both directions of a substrate plane.
12. A method according to any of clauses 1 to 9, wherein said plurality of measurement locations have an average spacing greater than 30 mm in both directions of a substrate plane.
13. A method according to any preceding clause, wherein said layout data comprises low resolution layout data, at a resolution defined by having a pixel size 0.5µm or greater.
14. A method according to any preceding clause, wherein said layout data comprises a pattern density spatial distribution.
15. A method according to any preceding clause, wherein said determining step comprises determining a spatial distribution of said parameter of interest over at least an exposure field.
16. A method according to any preceding clause, wherein said determining step uses substrate position data to determine a spatial distribution of said parameter of interest over the substrate, the trained model having been trained per-field based on the substrate location data.
17. A method according to clause 15 or 16, comprising using said spatial distribution of said parameter of interest to optimize one or more exposure settings in the manufacturing process.
18. A method according to any preceding clause, comprising performing said method for every substrate of a substrate lot in the manufacturing process.
19. A method according to any preceding clause, comprising an initial step of:
   obtaining training layout data comprising a similar type of data to said layout data;
   obtaining training metrology data corresponding to the training layout data; and
   training a machine learning model with said training metrology data and dense layout data to obtain said trained model.
20. A method according to clause 19, wherein said training metrology data comprises at least after-etch inspection metrology data measured subsequent to an etching and/or polishing step.
21. A method according to clause 20, wherein said training metrology data further comprises after-develop inspection metrology data measured prior to an etching and/or polishing step, the training step comprising training the machine learning model to interpolate a sparse sampling of after-develop inspection metrology data to a denser sampling of after-etch inspection metrology data.
22. A method according to any of clauses 19 to 21, wherein said training metrology data comprises densely sampled metrology data, sampled at more than 10000 points per substrate and/or at less than 100µm spacing in both directions of a substrate plane.
23. A method according to any of clauses 19 to 22, wherein said training step comprises training the machine learning model to interpolate a sparse sampling of said metrology data to a denser sampling of said metrology data using said layout data.
24. A method according to any of clauses 19 to 23, wherein said training step comprises using layout data relating to a small substrate area at the beginning of said training and increasing the substrate area covered by the layout data during said training until modeling accuracy of said model saturates.
25. A method according to any of clauses 19 to 24, wherein said layout data and training layout data comprise pattern density images.
26. A method according to clause 25, wherein said training metrology data comprises parameter of interest values describing the parameter of interest at a common point within all the training layout data images.
27. A method according to any of clauses 19 to 26, comprising obtaining a substrate scale fingerprint relating to the training metrology data; and
   training the model to apply the substrate scale fingerprint during interpolation to provide a full substrate parameter of interest distribution.
28. A method according to any of clauses 19 to 26, comprising training the model on a per-field basis based on field location on a substrate.
29. A computer program comprising program instructions operable to perform the method of any preceding clause, when run on a suitable apparatus.
30. A non-transient computer program carrier comprising the computer program of clause 29.
31. A processing arrangement comprising:
   a computer program carrier comprising the computer program of clause 29; and
   a processor operable to run said computer program.
32. A metrology device comprising the processing arrangement of clause 31.

**0059** The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

**0060** The breadth and scope of the present invention should not be limited by any of the above-described exemplary embodiments, but should be defined only in accordance with the following claims and their equivalents.

## Claims

1. A method for determining a parameter of interest relating to at least one structure formed on a substrate in a manufacturing process, the method comprising:
obtaining metrology data relating to a plurality of measurements of the parameter of interest at a respective plurality of measurement locations on the substrate;
obtaining layout data relating to a layout of a pattern to be applied to said structure, said pattern comprising said at least one structure;
obtaining a trained model, having been trained to interpolate said metrology data using said layout data to an expected value for the parameter of interest; and
determining a value for a parameter of interest at one or more locations on the substrate different from said measurement locations from said metrology data and layout data using said trained model.

2. A method as claimed in claim 1, wherein said parameter of interest is overlay.

3. A method as claimed in claim 1 or 2, wherein said metrology data comprises after develop inspection metrology data measured by a scatterometer.

4. A method as claimed in claim 1 or 2, wherein said metrology data comprises after etch inspection metrology data measured subsequent to an etching and/or a polishing step.

5. A method as claimed in any of claims 1 to 4, wherein said metrology data comprises one of: connectivity e-test data or scanning electron microscope measurement data.

6. A method as claimed in any preceding claim, wherein said layout data comprises a pattern density spatial distribution.

7. A method as claimed in any preceding claim, wherein said determining step comprises determining a spatial distribution of said parameter of interest over at least an exposure field.

8. A method as claimed in any preceding claim, wherein said determining step uses substrate position data to determine a spatial distribution of said parameter of interest over the substrate, the trained model having been trained per-field based on the substrate location data.

9. A method as claimed in claim 7 or 8, further comprising using said spatial distribution of said parameter of interest to optimize one or more exposure settings in the manufacturing process.

10. A method as claimed in any preceding claim, comprising an initial step of:
obtaining training layout data comprising a similar type of data to said layout data;
obtaining training metrology data corresponding to the training layout data; and
training a machine learning model with said training metrology data and dense layout data to obtain said trained model.

11. A method as claimed in claim 10, wherein said training metrology data comprises at least after-etch inspection metrology data measured subsequent to an etching and/or polishing step.

12. A method as claimed in claim 11, wherein said training metrology data further comprises after-develop inspection metrology data, the training step comprising training the machine learning model to interpolate a sparse sampling of after-develop inspection metrology data to a denser sampling of after-etch inspection metrology data.

13. A method as claimed in any of claims 10 to 12, wherein said layout data and training layout data comprise pattern density images.

14. A computer program comprising program instructions operable to perform the method of any preceding claim, when run on a suitable apparatus.

15. A non-transient computer program carrier comprising the computer program of claim 14.
